# EUROPEAN PATENT SPECIFICATION

(11) **EP 4 391 198 B1**
(45) Date of publication and mention of the grant of the patent: **29.07.2026**
(21) Application number: 22890473.6
(22) Date of filing: 07.11.2022
(51) Int. Cl.: H01M 50/502, H01M 50/569, H01M 50/211, H01M 50/24, H01M 10/658, H01M 10/48

(54) **BATTERY MODULE AND BATTERY PACK INCLUDING SAME**
BATTERIEMODUL UND BATTERIEPACK DAMIT
MODULE DE BATTERIE ET BLOC-BATTERIE LE COMPRENANT

(30) Priority: 08.11.2021 KR 20210152324
(43) Date of publication of application: 26.06.2024
(73) Proprietor: LG ENERGY SOLUTION, LTD., Seoul 07335 (KR)
(72) Inventor: JANG, Sung Hwan, Daejeon 34122 (KR); SEONG, Jun Yeob, Daejeon 34122 (KR); PARK, Myung Ki, Daejeon 34122 (KR)
(74) Representative: Goddar, Heinz J.
(86) International application number: PCT/KR2022/017343
(87) International publication number: WO 2023/080742

(56) References cited:
- EP-A1- 3 264 493
- CN-A- 111 312 964
- CN-A- 113 614 990
- JP-A- 2021 510 917
- KR-A- 20070 025 391
- KR-A- 20070 112 489
- KR-A- 20170 067 007
- KR-A- 20200 040 619
- KR-A- 20210 110 919
- KR-B1- 101 864 290
- US-A1- 2019 198 952
- US-A1- 2019 341 588

## Description

### [Technical Field]

The present invention relates to a battery module.

More particularly, the present invention relates to a battery module configured to be expandable, in which a sensing integrated bus bar is realized by coupling a bus bar and a sensing member by fitting coupling.

Further, the present invention relates to a battery pack including a stack of the battery modules.

### [Background Art]

Recently, secondary batteries that can be charged and discharged have been widely used as energy sources of wireless mobile devices. In addition, the secondary battery has attracted attention as an energy source of an electric vehicle, a hybrid electric vehicle, and the like, which are proposed as a solution for air pollution and the like of existing gasoline vehicles and diesel vehicles using fossil fuel. Accordingly, the types of applications using the secondary battery are diversifying due to the advantages of the secondary battery, and it is expected that the secondary battery will be applied to many fields and products in the future.

In addition, as an energy storage system (ESS), a power source for an electric vehicle (EV), or the like, there is an increasing demand for a battery module accommodating a plurality of secondary batteries electrically connected in series or in parallel and a battery pack composed of the battery modules.

Such a battery module or battery pack includes an external housing made of a metal material to protect a plurality of secondary batteries from external impacts or receive and store the secondary batteries.

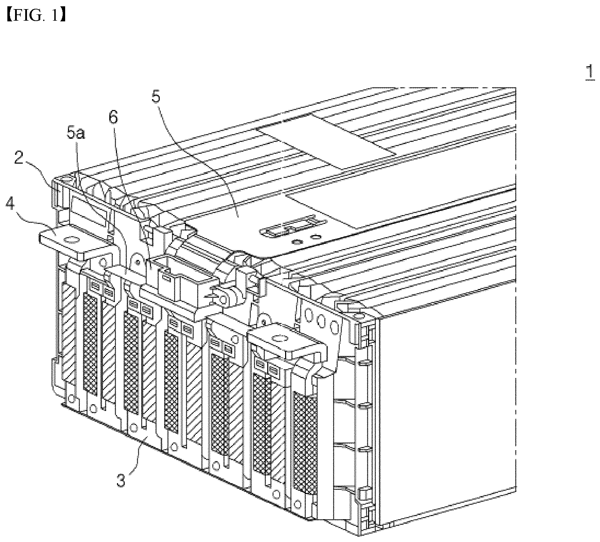

FIG. 1 is a partial perspective view of a conventional general battery module 1. As shown in the drawing, a battery cell assembly in which several tens of battery cells are stacked is accommodated in one module case. The conventional battery module 1 has the following problems.

First, due to a structure in which a bus bar frame 2 is installed at a front end of a module case and both a terminal bus bar 4 and an inter-bus bar 3 are installed in the bus bar frame 2, in order to provide a space in which the bus bars are installed, the shape of the bus bar frame 2 has to be complicatedly molded. In addition, since a sensing line 5a and a connector 6 are installed together in the bus bar frame 2, the structure is more complicated.

Second, due to a complex assembly structure in which a sensing plate 5 is installed in the module case and the sensing line 5a drawn out therefrom is coupled to the terminal bus bar 4 and the inter-bus bar 3 and laser-welded, there is a problem in that a manufacturing process increases and a manufacturing cost increases as a result.

Third, since a single battery cell is stacked only in a thickness direction thereof, space utilization of battery cell arrangement may be reduced and a degree of freedom in design may be reduced, and thus there is a limitation in configuring a battery pack by combining these types of modules. That is, it is not easy to configure the battery module or the battery pack so as to correspond to a limited space such as a vehicle or various types of spaces. In addition, since about several tens of battery cells are stacked in one module, when ignition occurs in one battery cell, there is a risk that flame easily propagates to other battery cells and the module burns out in a short time.

Accordingly, it is desirable to develop a battery-module-related technology capable of securing rigidity while simplifying an assembly process by simplifying the coupling of a bus bar and a sensing member, and increasing a degree of freedom in design of a battery module and a battery pack.

The document KR 2021 0110919 A discloses a battery module with a bus bar directly joined to a PCB terminal portion.

The document EP 3 264 493 A1 discloses a battery module having stacked cartridges accommodating upper and lower battery cells.

The document US 2019/341588 A1 discloses a vehicular battery pack having layered pouch cells and integrated cooling walls.

The document CN 111 312 964 A a battery pack having a sealed housing with internal structural beams dividing vacuum chambers accommodating cell strings.

### [Related-Art Document]

### [Patent Document]

Korean Registered Patent Publication No. 10-2259416

### [Disclosure]

### [Technical Problem]

The present invention has been devised to solve the above problem, and the present invention is directed to providing an expandable battery module capable of improving space utilization of a battery module and a battery pack by connecting battery cells in a longitudinal direction in addition to a thickness direction of the battery cell.

The present invention is also directed to providing a battery module having a sensing integrated bus bar structure in which coupling between a bus bar and a sensing member is simplified.

The present invention is also directed to providing a battery pack including a stack of the battery modules.

### [Technical Solution]

A battery module according to the present invention for solving the above problems includes: a battery cell assembly including two or more longitudinal unit cells, each of the two or more longitudinal unit cells including two or more battery cells arranged in a row in a longitudinal direction, wherein the battery cell includes a pair of electrode leads at both ends in the longitudinal direction, and each of the two or more longitudinal unit cells are stacked in two or more columns in a thickness direction of the battery cell; a bus bar coupled to each of the pair of electrode leads of the battery cell included in the battery cell assembly and electrically connecting the battery cells, a sensing member coupled to the bus bar and sensing electrical characteristics of the battery cell, and a module case accommodating the battery cell assembly, the bus bar, and the sensing member, wherein the bus bar and the sensing member are fastened by fitting coupling in which one of the bus bar and the sensing member is fitted int the other thereof so as to be fastened to the other.

As one example, the bus bar may compires an inter-bus bar to which each of the electrode leads of the battery cells located at a front end of the longitudinal unit cells and a rear end of the longitudinal unit cells is coupled.

Specifically, the same number of columns of longitudinal unit cells may be disposed on each of both sides of the inter-bus bar in the thickness direction of the battery cell, and the electrode leads of the battery cells located at the front and rear ends of the longitudinal unit cells disposed on each of the both sides may be bent toward the inter-bus bar and coupled to the inter-bus bar.

In addition, as one example, a first sensing member may be installed on a rear side of the inter-bus bar, and the first sensing member may include a first hook portion on a front surface thereof facing the inter-bus bar, and the inter-bus bar is coupled to the first sensing member by being fitted the first hook portion.

As another example, the battery module may further include a heat propagation prevention plate installed to extend in the longitudinal direction of the battery cell across a front end and a rear end of the module case between the two or more columns of the longitudinal unit cells.

Specifically, the inter-bus bar may be installed through each of a front end portion and a rear end portion of the heat propagation prevention plate, and the electrode leads of the battery cells located at the front and rear ends of the longitudinal unit cells disposed on each of both sides of the heat propagation prevention plate may be bent toward the inter-bus bar and coupled to the inter-bus bar.

**In** addition, an insulating member may be installed on each of a left side surface and a right side surface of the heat propagation prevention plate at the front end portion and the rear end portion, and the inter-bus bar may be installed through the insulating member and the heat propagation prevention plate at each of the front end portion and the rear end portion.

In addition, the first sensing member may be installed on a rear side of the inter-bus bar, and the first sensing member may include first hook portions on a front surface thereof facing the inter-bus bar such that the inter-bus bar is coupled to the first sensing member by being fitted between the first hook portions.

More specifically, the first sensing member may be coupled by passing through the heat propagation prevention plate at the rear side of the inter-bus bar, the first sensing member may include a second hook portion fitted into an edge of a through portion of the heat propagation prevention plate, and when the second hook portion is fitted into the edge of the through portion to couple the first sensing member and the heat propagation prevention plate, the inter-bus bar may be fitted the first hook portion, and the first sensing member is fitted into and coupled to the inter-bus bar.

According to another embodiment of the present invention, the bus bar may comprise a terminal bus bar coupled to the electrode leads of the battery cells, which face in the longitudinal direction, in the longitudinal unit cell.

As one example, the terminal bus bar may include a first terminal bus bar coupled to an electrode lead or electrode leads of one side among the electrode leads of the battery cells facing each other in the longitudinal direction, and a second terminal bus bar coupled to an electrode lead or electrode leads of the other side among the electrode leads of the battery cells facing each other in the longitudinal direction.

Specifically, a second sensing member may be installed on a rear side of the terminal bus bar, and the second sensing member may include a coupling hook portion on a front surface facing the terminal bus bar, and the terminal bus bar is coupled to the second sensing member by being fitted the coupling hook portion.

As another example, the battery module may further include a heat propagation prevention plate installed to extend in the longitudinal direction of the battery cell across a front end and a rear end of the module case between the two or more columns of the longitudinal unit cells, wherein the second sensing member may be coupled to the heat propagation prevention plate.

As one example, a thermally conductive adhesive resin layer may be disposed in at least one of a space between the module case covering an upper portion of the battery cell assembly and the battery cell assembly, and a space between the battery cell assembly and the module case located below the battery cell assembly.

A battery pack according to another aspect of the present invention includes a battery module stack in which the battery module in plural in at least one of the longitudinal direction and the thickness direction of the battery cell are stacked.

### [Advantageous Effects]

According to the present invention, it is possible to obtain an expandable battery module capable of improving space utilization of a battery module and a battery pack by connecting battery cells in a longitudinal direction in addition to a thickness direction.

In addition, it is possible to secure the rigidity of a sensing member and a bus bar assembly while simplifying an assembly process, by realizing a sensing integrated bus bar structure suitable for the expandable battery module. Accordingly, it is possible to improve safety by preventing temperature rise of the battery module and the occurrence of a fire.

### [Brief Description of the Drawings]

FIG. 1 is a partial perspective view of a conventional general battery module.
FIG. 2 is an exploded perspective view of a battery module of the present invention.
FIG. 3 is a perspective view illustrating a structure of a heat propagation prevention plate included in the battery module of FIG. 2.
FIG. 4 is a perspective view illustrating an assembled exterior of the battery module of FIG. 2.
FIG. 5 is a set of a perspective view, a front view, and a plan view illustrating a structure of a first sensing member, which is an example of a sensing member according to the present invention.
FIG. 6 is an essential-portion enlarged view of portions P and P' of FIG. 2, and is a perspective view illustrating a coupling structure of a bus bar and a first sensing member according to a first embodiment of the present invention.
FIG. 7 is a perspective view illustrating the coupling structure of the bus bar and the first sensing member of the first embodiment, viewed from a direction different from that of FIG. 6.
FIG. 8 is a set of front and rear perspective views illustrating a structure of a second sensing member, which is an example of the sensing member according to the present invention.
FIG. 9 is an essential-portion enlarged view of portion Q of FIG. 2 and is a perspective view illustrating a coupling structure of a bus bar and a second sensing member according to a second embodiment of the present invention.
FIG. 10 is a perspective view illustrating the coupling structure of the bus bar and the sensing member of the second embodiment, viewed from a direction different from that of FIG. 9.
FIG. 11 is a cross-sectional view taken along line A-A' of FIG. 4.
FIG. 12 is a schematic view of a battery pack including a battery stack composed of the battery module of the present invention.

### [Description of Reference Numerals]

10: battery cell
11 and 12: leads
100: battery cell assembly
110: longitudinal unit cell
200: bus bar
210 and 210': inter-bus bars
220 and 220': terminal bus bars
300: sensing member
310: first sensing member
311: first sensing pin
312: first hook portion
313: second hook portion
320: second sensing member
320a and 320a': coupling protrusions
321 and 322: coupling hook portion
323: second sensing pin
340: support block
341: support block hook
400: module case
410: C-shaped wall
420: I-shaped wall
430 and 440: front end plate and rear end plate
500: heat propagation prevention plate
510: body portion
511: partition
510C: venting channel
512 and 512': inter-bus bar coupling long holes
513 and 513': first sensing member coupling long holes
514 and 514': venting long holes
515: support block coupling hole
516: second sensing member coupling hole
520: support plate
521: inter-bus bar coupling hole
600: insulating member
R: thermally conductive adhesive resin layer
T: adhesive
1000: battery module
1000': battery module stack
2100: battery pack case
2000: battery pack

### [Best Mode]

Hereinafter, the present invention will be described in detail. Prior to this, terms or words used in the present specification and claims should not be restrictively interpreted as ordinary meanings or dictionary-based meanings, but should be interpreted as meanings and concepts consistent with the technical ideas of the present invention on the basis of the principle that an inventor can properly define the concept of a term to describe and explain his or her invention in the best way.

Throughout this specification, it should be understood that terms such as "include" or "have" are intended to indicate that there is a feature, number, step, operation, component, part, or a combination thereof described on the specification, and they do not exclude in advance the possibility of the presence or addition of one or more other features or numbers, steps, operations, components, parts or combinations thereof.

Further, when a portion such as a layer, a film, an area, a plate, or the like is referred to as being "on" another portion, this includes not only the case in which the portion is "directly on" the another portion but also the case in which still another portion is interposed therebetween. In contrast, when a portion such as a layer, a film, an area, a plate, or the like is referred to as being "below" another portion, this includes not only the case in which the portion is "directly below" the another portion but also the case in which still another portion is interposed therebetween. In addition, to be disposed "on" in the specification of the present invention may include the case disposed at the lower portion as well as the upper portion.

A battery module according to the present invention a battery cell assembly in which two or more longitudinal unit cells, each of which two or more battery cells having electrode leads at both ends in the longitudinal direction are arranged in a row in the longitudinal direction, are stacked in two or more columns in the thickness direction of the battery cell, a bus bar coupled to the electrode leads of the battery cells included in the battery cell assembly and configured to electrically connect the battery cells, a sensing member coupled to the bus bar and configured to sense electrical characteristics of the battery cell, and a module case configured to accommodate the battery cell assembly, the bus bar, and the sensing member.

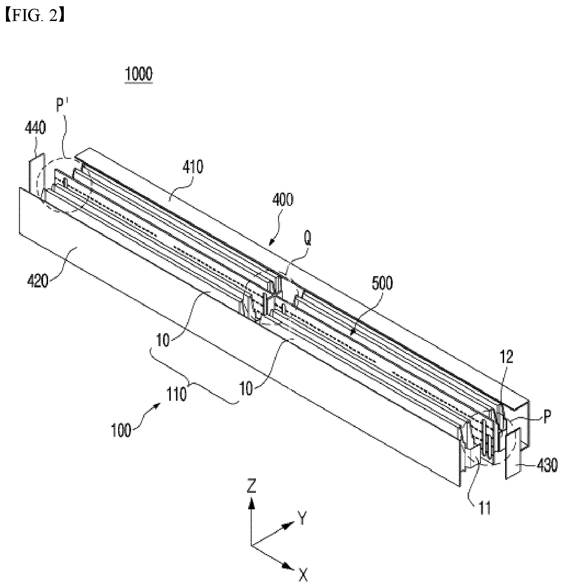

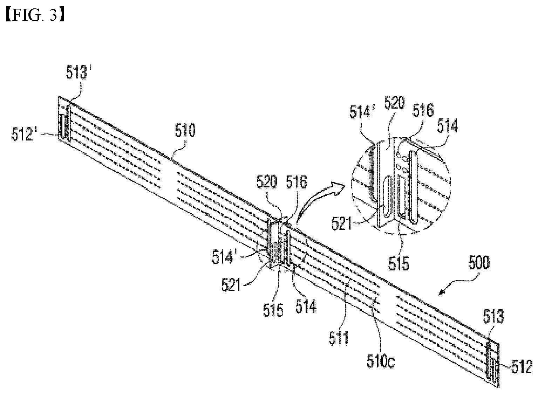

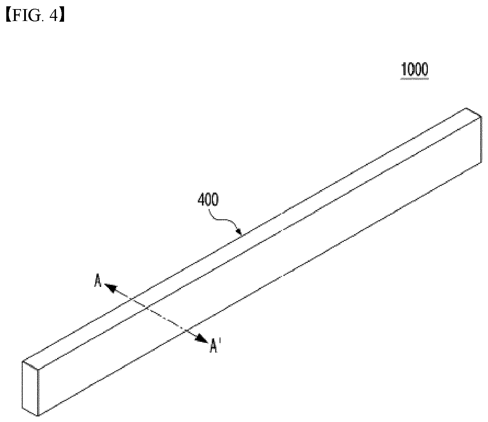

FIG. 2 is an exploded perspective view of the battery module of the present invention, FIG. 3 is a perspective view illustrating a structure of a heat propagation prevention plate included in the battery module of FIG. 2, and FIG. 4 is a perspective view illustrating an assembled exterior of the battery module of FIG. 2.

As shown in FIG. 2, the present invention includes a battery cell assembly 100 including a longitudinal unit cell 110, and a module case 400 in which the battery cell assembly 100 is accommodated. In FIG. 2, based on a typical pouch-shaped battery cell 10 having leads 11 and 12 at both ends thereof and extending long in a longitudinal direction, an X direction is the longitudinal direction of the battery cell 10 or the battery module (case), a Y direction (a stacking direction of the battery cells) is a thickness direction of the battery cell 10 or the module case 400, and a Z direction is an up and down direction.

The battery cell 10 of the present invention is directed to a battery cell 10 (a so-called bidirectional battery cell (bidirectional pouch cell)) in which the leads 11 and 12 are provided at both ends in the longitudinal direction. According to this configuration, in one battery cell 10, since a positive electrode lead 11 and a negative electrode lead 12 are provided to protrude from both ends, respectively, interference does not exist between the leads, and thus, an area of the electrode lead can be increased, and a coupling operation of the electrode lead and a bus bar can be performed more easily.

The battery cell assembly 100 of the present invention includes a battery cell bundle, in which two or more of these bidirectional battery cells are arranged in a line in the longitudinal direction and the electrode leads of the battery cells 10, which face each other in the longitudinal direction, are electrically connected to each other, as the longitudinal unit cell 110. Although two battery cells are connected in the longitudinal direction to compose the longitudinal unit cell in FIG. 2, two or more battery cells may be connected in the longitudinal direction. The number of the battery cells 10 connected in the longitudinal direction is not limited in principle as long as a space of the battery pack, in which the battery module case 400 or a battery module 1000 is installed, is allowed. However, approximately two to four battery cells 10 may be connected in the longitudinal direction since the space of the battery module 1000 or battery pack that can be actually installed in a vehicle is limited. In addition, the number of the battery cells 10 connected in the longitudinal direction may be changed according to the size (length) of the battery cell 10 to be connected. As described above, in the present specification, an assembly of the battery cells 10 formed by arranging two or more battery cells 10, each of which has the leads 11 and 12 provided at both ends in the longitudinal direction, in a line to face each other and electrically connecting the facing leads 11 and 12 of the battery cells are referred to as the longitudinal unit cell 110.

The battery cell assembly 100 included in the battery module 1000 of the present invention in which the longitudinal unit cells 110 in two or more columns in the thickness direction (X direction) of the battery cell 10 are stacked. The number of columns in which the longitudinal unit cells 110 are stacked also depends on the allowable space of the battery module 1000 and the battery pack, the size of the battery cell 10, and the like. In addition, the number of the battery cells 10 in the longitudinal direction, the number of columns, and the like may be determined in consideration of the required capacity of an electric device. As described above, according to the present invention, since the number of the battery cell assemblies 100, which are accommodated in the module case 400, in the longitudinal direction of the battery cell and the number of columns can be adjusted, a degree of freedom in design is improved. In addition, when about two to four battery cell assemblies 100 are stacked in the longitudinal direction and the resultant stack is stacked in about two to six columns in the thickness direction of the battery cell instead of stacking several tens of the battery cell assemblies 100 as in the related art, the battery cell assembly 100 can be configured in a compact manner. In addition, when the battery cell assembly 100 composed of a small number of the battery cells 10 is accommodated in a separate module case 400, and the battery module 1000 including the module case 400 is stacked in the longitudinal direction or the thickness direction of the battery cell 10 like Lego blocks, the battery pack may be freely configured in consideration of a space in which the battery module 1000 is installed or an installation space of the battery pack. For example, when the battery module 1000 is stacked in the longitudinal direction, even when the battery cells of the longitudinal unit cell 110 are not connected longer in the longitudinal direction, the same effect can be achieved. Accordingly, an individual battery module (unit module) can be configured to be more compact in size. In addition, the degree of freedom in design may be improved by stacking the battery module 1000 in the thickness direction of the battery cell as many as the required number. With the structure in which several tens of battery cells are stacked in one module case as shown in FIG. 1, it is difficult to configure the battery pack as desired. That is, since the minimum units of the battery cells included in the battery module constituting the battery pack are different, the degree of freedom in design of the conventional battery module 1 is inevitably reduced.

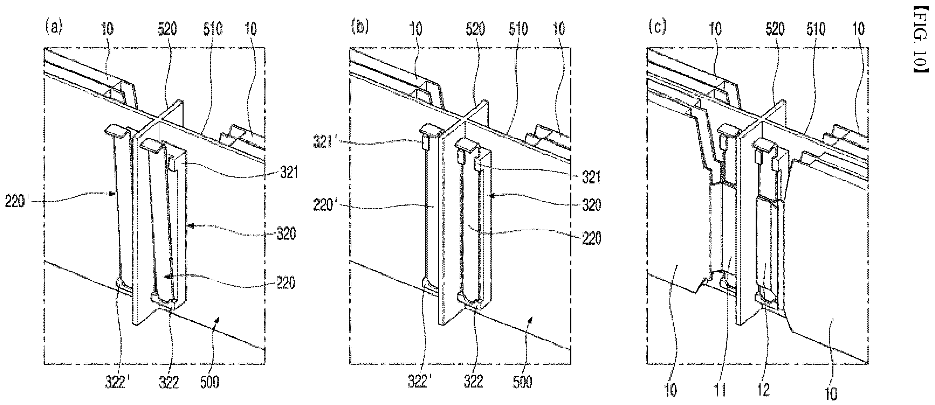

In addition, for example, when ignition occurs in some battery cells included in the battery module, in the battery module 1 of FIG. 1, flame easily propagates to the adj acent battery cells. However, in a structure of the battery module 1000 of FIG. 2 or a battery pack disclosed in FIG. 10, which will be described below, since the battery cell assembly 100 having a small number of the battery cells 10 is separately accommodated in the battery module 1000, even when ignition occurs in the battery cells 10 in one battery module 1000, the ignition is difficult to propagate to other battery modules 1000.

As described above, the battery cell assembly 100 of the present invention has the form in which the battery cell assembly 100 composed of a specific number of the battery cells 10 connected in the longitudinal direction and the thickness direction of the battery cell is accommodated in each module case 400. Accordingly, various types of battery packs may be manufactured according to a stacking (design) method of the battery module 1000 including the battery cell assembly 100, and thus the battery module 1000 of the present invention can be referred to as an expandable module.

The battery cell assembly 100 of the present invention shown in FIG. 2 has a so-called 2P4S connection structure and is composed of a total of eight battery cells 10 by connecting two battery cells 10 in the longitudinal direction and stacking the longitudinal unit cells 110 in four columns.

However, a battery cell assembly composed by stacking the two longitudinal unit cells 110 in even-numbered columns, such as two columns (1P4S), six columns (3P4S), or eight columns (4P4S), may also be possible by varying the number of columns of the two longitudinal unit cells 110 connected in the longitudinal direction. In addition, instead of the structure connecting two longitudinal unit cells in the longitudinal direction, a structure connecting three (1P6S, 2P6S, 3P6S, ..., or the like) longitudinal unit cells, and a structure connecting four or more (1P8S, 2P8S, 3P8S, ..., or the like) longitudinal unit cells is also possible. For example, it is an advantage of the present invention that a stack structure of each of the longitudinal unit cell 110 and battery cell assembly can be changed in various and scalable ways according to a design request of the above-described battery module and battery pack.

Although not shown in the drawing, an insulating plate or an insulating sheet may be installed between the columns of the longitudinal unit cells 110. In one embodiment of the present invention, a heat propagation prevention plate 500 is installed between the columns of the longitudinal unit cells 110.

Referring to FIG. 3, the heat propagation prevention plate 500 is installed to extend in the longitudinal direction of the battery cell 10 across front and rear ends of the module case 400 between the columns of the longitudinal unit cells 110 constituting the battery cell assembly 100. The heat propagation prevention plate 500 may serve to prevent heat propagation between the longitudinal unit cells 110 when flame is generated due to overheating or ignition. Specifically, the heat propagation prevention plate 500 has a hollow structure in which a venting channel 510C capable of discharging gas and flame is provided. The venting channel 510C may be divided into a plurality of venting channels 510C through a partition wall 511 and may discharge gas or flame generated in the module to the outside of the module. The heat propagation prevention plate 500 has a size and a length capable of completely covering the longitudinal unit cell 110 so as to discharge gas or flame generated from the battery cell, particularly, the electrode lead portion. As shown in FIG. 3, a body portion 510 of the heat propagation prevention plate 500 is provided long enough to extend across the front and rear ends of the module case 400. The heat propagation prevention plate 500 may also serve as an installation base, on which a bus bar or an electrode lead to be described below, or a support member for supporting the bus bar and the electrode lead can be installed. To this end, the heat propagation prevention plate 500 of FIG. 3 includes installation holes in which various members can be installed. In addition, a support plate 520 for supporting the electrode leads of the battery cells 10, which face in the longitudinal direction, and the bus bar, to which the electrode leads are coupled, is provided at a central portion of the body portion 510 of the heat propagation prevention plate 500 to be perpendicular to the body portion 510. Specifically, inter-bus bar coupling long holes 512 and 512' are provided in a front end portion and a rear end portion of the body portion 510 of the heat propagation prevention plate 500, respectively, and first sensing member coupling long holes 513 and 513' are provided respectively behind the inter-bus bar coupling long holes 512 and 512'. In addition, venting long holes 514 and 514' each having a size similar to that of the first sensing member coupling long hole are respectively provided on left and right sides of the support plate 520 at the central portion of the body portion 510. Since the long holes communicate with the venting channel 510C described above, gas or flame generated from the electrode lead portion can be introduced into the venting channel 510C to be discharged to the outside. Coupling holes 516 to which a second sensing member 320 to be described below can be coupled and a support block coupling hole 515 for coupling a support block provided on a rear surface of the second sensing member are provided between the support plate 520 at the central portion of the body portion 510 and each of the venting long holes 514 and 514'.

Meanwhile, a through hole (long hole) 521 to which an inter-bus bar, to which the electrode leads facing in the longitudinal direction are coupled, is coupled is provided in the support plate 520.

In the expandable battery module of the present invention, when the heat propagation prevention plate 500 having the above-described structure is installed between the longitudinal unit cells 110, gas and flame can be easily discharged as described above, and bus bars and electrode leads can be conveniently installed.

In addition, the battery module 1000 of the present invention includes a bus bar 200 that is coupled to the electrode leads 11 and 12 of the battery cells 10 included in the battery cell assembly 100 and electrically connects the battery cells. As will be described below, the bus bar 200 may include an inter-bus bar 210 and a terminal bus bar 220.

In addition, the battery module 1000 of the present invention includes a sensing member 300 coupled to the bus bar and configured to sense electrical characteristics of the battery cell 10. The sensing member 300 may include a first sensing member 310 coupled to the inter-bus bar 210 and a second sensing member 320 coupled to the terminal bus bar 220. The sensing member 300 may sense electrical characteristics of the battery cell 10 included in the module, such as voltage, current, resistance, and the like. The sensing member 300 may be connected to an external device, such as a battery management system (BMS), an electronic control unit (ECU), or a controller, with a cable and may transmit sensed electrical characteristic values thereto.

A characteristic point of the present invention is that the bus bar 200 and the sensing member 300 are easily and firmly coupled by fitting coupling. That is, one of the bus bar 200 and the sensing member 300 is coupled to another one thereof by fitting coupling such as hooking coupling without using a laser welding method or the like as in the related art. Accordingly, the bus bar 200 of the present invention can substantially realize a sensing integrated bus bar structure integrally coupled to the sensing member 300. A fitting member for fitting coupling such as a catching protrusion and a hook portion may be provided in any one of the bus bar 200 and the sensing member 300. The shape of the fitting coupling may vary depending on the type and position of the bus bar. A detailed description thereof will be provided in detail according to embodiments to be described below.

The present invention includes the module case 400 accommodating the battery cell assembly 100, the bus bar 200, and the sensing member 300. The module case 400 has a rectangular parallelepiped structure extending long in the longitudinal direction to accommodate the unique battery cell assembly 100 of the present invention. In FIG. 2, the module case 400 is provided by coupling a C-shaped wall 410 and an I-shaped wall 420, but the present invention is not limited thereto. For example, a form in which two C-shaped walls disposed left and right or up and down are combined is possible, and a form in which upper, lower, left, and right cases are separated and coupled through welding, hooking coupling, a fastening member, and the like is also possible. In addition, the module case 400 of the present invention includes a front end plate 430 and a rear end plate 440. The front end plate 430 and the rear end plate 440 are coupled to coupling bodies of the C-shaped wall and the I-shaped wall to close front and rear sides of the module, respectively.

FIG. 4 illustrates an exterior of the battery module 1000 in which the battery cell assembly 100 and the like are accommodated, assembled, and coupled.

### [Modes of the Invention]

Hereinafter, embodiments related to a specific coupling structure of the bus bar 200 and the sensing member 300, which are essential portions of the present invention, will be described.

### (First embodiment)

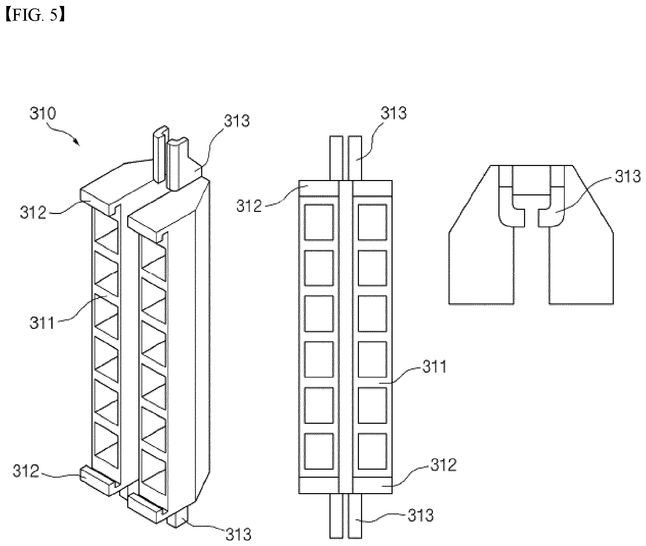

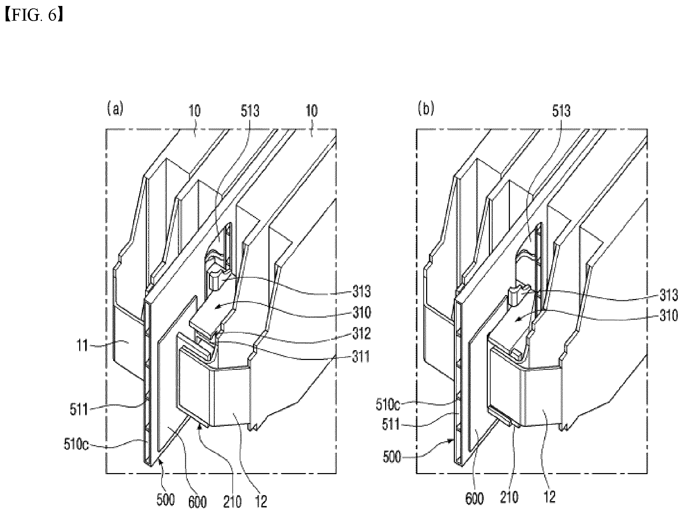

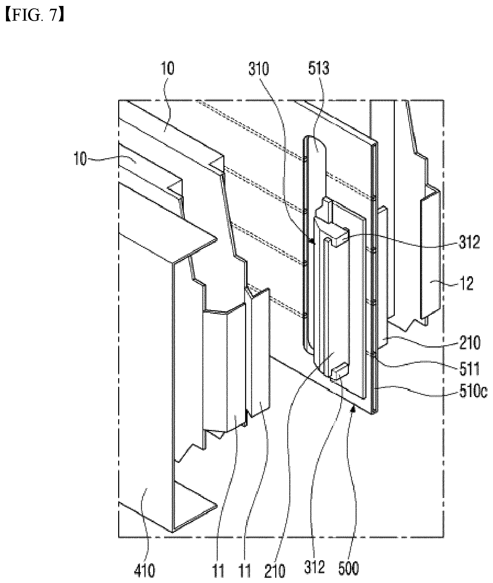

FIG. 5 is a set of a perspective view, a front view, and a plan view illustrating a structure of a first sensing member, which is an example of the sensing member according to the present invention, FIG. 6 is an essential-portion enlarged view of portions P and P' of FIG. 2, and is a perspective view illustrating a coupling structure of a bus bar and the first sensing member according to a first embodiment of the present invention, and FIG. 7 is a perspective view illustrating the coupling structure of the bus bar and the first sensing member of the first embodiment, viewed from a direction different from that of FIG. 6.

The present embodiment is related to a case in which the bus bar 200 is the inter-bus bar 210 to which the electrode leads 11 and 12 of the battery cells 10 located at each of the front and rear ends of the longitudinal unit cells are coupled, and also a case in which the inter-bus bar 210 and the first sensing member 310 are fastened by fitting and coupling the inter-bus bar 210 to the first sensing member 310.

Referring to FIG. 5, the first sensing member 310 has body portions facing each other on both sides thereof and has an approximately C-shape in which the facing body portions are connected to each other at a rear side (see the plan view of FIG. 5). First hook portions 312, between which the inter-bus bar can be fitted, are respectively provided to protrude from upper and lower ends of a front surface of each of the body portions, and a plurality of sensing pins 311 (first sensing pins) are provided on the front surface of the body portion between the first hook portions 312. Accordingly, the inter-bus bar is fitted between the first hook portions 312 and comes into contact with the sensing pins 311 to be electrically connected to the first sensing member 310. In addition, the first sensing member 310 has a second hook portion 313 on each of an upper portion and a lower portion of the body portion thereof. The second hook portion 313 is a portion fitted into and coupled to an edge of a through portion (the first sensing member coupling long hole 513 or 513') of the heat propagation prevention plate 500 when the first sensing member 310 is coupled to the heat propagation prevention plate 500 described above.

In FIGS. 6 and 7, for convenience of description, the above-described heat propagation prevention plate 500 is illustrated as being located between the longitudinal unit cells 110. However, since the inter-bus bar 210 and the first sensing member 310 can be coupled to each other even without the heat propagation prevention plate 500, the coupling structure in a case in which the heat propagation prevention plate 500 is not present will be described first, and then the coupling structure in a case in which the heat propagation prevention plate 500 is interposed will be described.

The longitudinal unit cells 110 in even-numbered columns are disposed to have the same number of columns on each of both sides of the inter-bus bar 210 in the thickness direction of the battery cell. In this case, the electrode leads 11 and 12 of the battery cells 10 located at the front and rear ends of the longitudinal unit cells disposed on the above both sides are bent toward the inter-bus bar 210 and coupled to the inter-bus bar 210. FIGS. 6 and 7 illustrate the coupling structure of the electrode leads of the battery cells 10 at the front end of the longitudinal unit cell 110, but the coupling structure of the electrode leads at the rear end of the longitudinal unit cell 110 is the same.

In the present embodiment, a 2P4S battery cell coupling structure is illustrated, and two columns of the battery cells 10 are disposed on each of left and right sides with respect to the inter-bus bar 210, two electrode leads 11 protrude from the battery cells 10 on the left side are bent rightward toward the inter-bus bar 210, and two electrode leads protrude from the battery cells 10 on the right side are bent leftward toward the inter-bus bar 210. The bent electrode leads are each coupled to the inter-bus bar 210 by welding or the like and electrically connected thereto. As will be described below, the longitudinal unit cells are coupled to each other by an adhesive, a double-sided tape, or the like, and thus, when the electrode leads 11 and 12 are coupled to the inter-bus bar 210, the inter-bus bar 210 may also be fixed to the front and rear ends of the battery cell assembly 100

The inter-bus bar 210 is provided in a substantially flat plate shape so that the electrode leads on the left and right sides can be bent and welded, but the present invention is not limited thereto. However, since an edge portion of the inter-bus bar 210 is provided in a flat plate shape, the flat edge portion can be easily fitted between and coupled to the first hook portions 312 of the first sensing member 310.

In this case, the first sensing member 310 is installed at a rear side of the inter-bus bar 210. The first sensing member 310 has the sensing pins 311 and the first hook portions 312 on a front surface thereof facing the inter-bus bar 210 so that the inter-bus bar 210 can be fitted between the first hook portions 312 and coupled to the first sensing member 310. The first hook portion 312 provided to protrude from each of upper and lower portions of the front surface of the first sensing member 310. In addition, the first hook portion 312 may be provided in a pair on left and right portions of the front surface of the first sensing member 310 (see FIG. 5). Although FIG. 6 is a view viewed from a right side of the battery cell assembly 100, referring to FIG. 7 viewed from a left side, it can be seen that the inter-bus bar 210 is coupled to the first hook portions 312 provided on the upper and lower portions of the left body portion of the first sensing member 310.

As described above, in the expandable battery module unique to the present invention, the inter-bus bar 210 is provided at each of the front and rear ends of the longitudinal unit cells, and the first sensing member 310 is easily coupled to the rear side of the inter-bus bar 210 by fitting coupling, thereby significantly reducing an assembly process of the bus bar 200 and the first sensing member 310.

Meanwhile, a case in which the above-described heat propagation prevention plate 500 is installed between the longitudinal unit cells 110 will be described as a modified example of the present embodiment. In this case, the assembly procedure is slightly changed.

Referring to FIGS. 3 and 6, the inter-bus bar 210 is fitted into each of the inter-bus bar coupling long holes 512 and 512' provided at the front and rear end portions of the heat propagation prevention plate 500. In this case, an insulating member 600 may be installed on each of left and right side surfaces of the heat propagation prevention plate 500 in order to fix the inter-bus bar 210 to the heat propagation prevention plate 500. A long hole (not shown) into which the inter-bus bar 210 can be fitted is also provided in the insulating member 600. As shown in FIGS. 6 and 7, when the insulating member 600 is located on each of the left and right side surfaces of the front end portion of the heat propagation prevention plate 500 and the inter-bus bar 210 is fitted through the insulating member 600 and the heat propagation prevention plate 500, the inter-bus bar 210 is coupled to the heat propagation prevention plate 500.

Thereafter, the first sensing member 310 is located on the rear side of the inter-bus bar 210 across a middle portion of the left and right body portions of the first sensing member 310 on the first sensing member coupling long hole 513 or 513' of the heat propagation prevention plate 500. The first sensing member 310 of the present modified example is coupled to the inter-bus bar 210 through the first sensing member coupling long hole 513 or 513', has a symmetrical C-shape, and includes the upper and lower first hook portions, which protrude toward the inter-bus bar 210 and are provided on the front surface facing the inter-bus bar 210, on each of the left and right sides of the heat propagation prevention plate 500. In addition, the sensing pins 311 are disposed between the upper and lower first hook portions 312 (see FIGS. 5 and 6).

In particular, in the present embodiment, the first sensing member 310 include the second hook portions 313, which are fitted into the edge portion of the through hole (the first sensing member coupling long hole 513 or 513') of the heat propagation prevention plate 500, on the upper and lower portions of the body portion, that is, upper and lower portions of the body portion on a rear side of the first hook portion 312. That is, the first sensing member 310 is coupled to the inter-bus bar 210 by the first hook portions 312 and coupled to the heat propagation prevention plate 500 by the second hook portions 313, thereby further improving coupling rigidity.

The hook coupling of the first sensing member 310 and the inter-bus bar 210 can be performed before or after the coupling between the inter-bus bar 210 and the electrode leads of the battery cell assembly 100.

FIGS. 6 and 7 illustrate that hook coupling is made after the coupling of the electrode leads of the inter-bus bar 210 and the battery cell assembly 100.

Specifically, in FIG. 6A, in a state in which the electrode leads of the battery cells 10 are bent toward the inter-bus bar 210 and welded to the left and right sides of the front surface of the inter-bus bar 210, respectively, when the first sensing member 310 is tilted forward and downward so that the second hook portion 313 of the first sensing member 310 is fitted into the edge of the long hole of the heat propagation prevention plate 500, the first hook portions 312 of the first sensing member 310, which protrude forward, are also fitted into and coupled to the upper and lower portions of the inter-bus bar 210 (see FIG. 6B). Accordingly, the electrode leads 11and 12, the inter-bus bar 210, the first sensing member 310, and the heat propagation prevention plate 500 form one assembly, thereby realizing the firm sensing integrated bus bar structure.

### (Second embodiment)

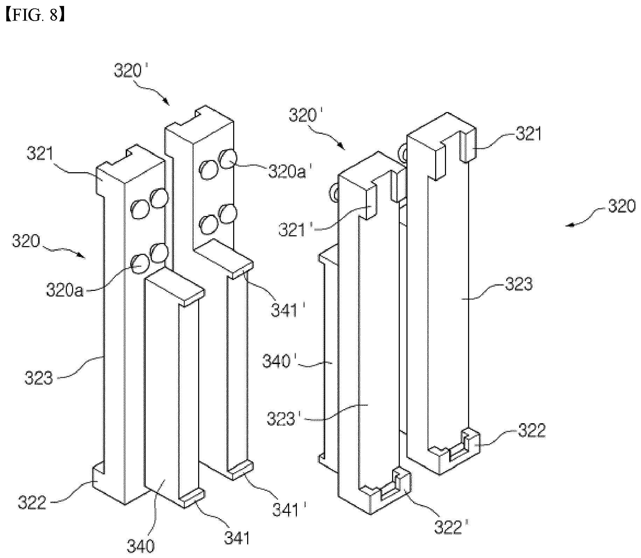

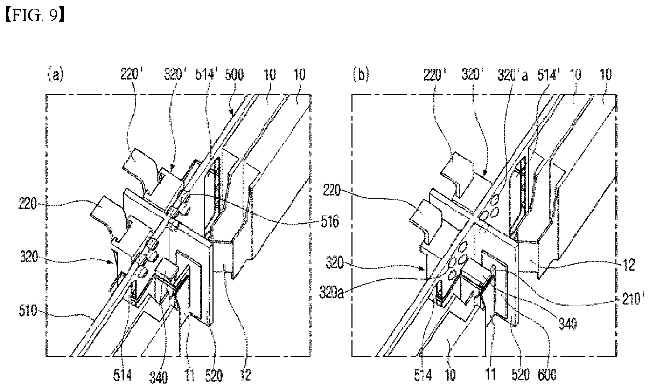

FIG. 8 is a set of front and rear perspective views illustrating a structure of a second sensing member, which is an example of the sensing member according to the present invention, FIG. 9 is an essential-portion enlarged view of portion Q of FIG. 2 and is a perspective view illustrating a coupling structure of a bus bar and the sensing member according to a second embodiment of the present invention, and FIG. 10 is a perspective view illustrating the coupling structure of the bus bar and the sensing member of the second embodiment, viewed from a direction different from that of FIG. 9.

The present embodiment illustrates a case in which the bus bars are terminal bus bars 220 and 220' coupled to the electrode leads of the battery cells 10 facing in the longitudinal direction in the longitudinal unit cell 110. That is, the type of the bus bar coupled to the electrode leads at the front and rear ends of the longitudinal unit cell 110 and the type of the bus bar coupled to the electrode leads between the longitudinal unit cells 110 may be different.

Specifically, the terminal bus bar may be configured with a first terminal bus bar 220 coupled to one electrode lead or electrode leads among the electrode leads of the battery cells 10, which face each other in the longitudinal direction, and a second terminal bus bar 220' coupled to the other electrode lead or electrode leads among the electrode leads of the battery cells 10.

The terminal bus bar may also be easily coupled to the sensing member by fitting coupling.

Referring to FIG. 8, second sensing members 320 and 320', which are respectively fitted to the terminal bus bars 220 and 220', respectively include sensing pins (second sensing pins) 323 and 323' provided on front surfaces, which face the terminal bus bars 220 and 220', and coupling hook portions 321 and 322 and 321' and 322', to which the terminal bus bars are fitted and which are respectively provided on upper and lower ends of the sensing pins 323 and 323'. Accordingly, when the terminal bus bars are fitted between and coupled to the coupling hook portions 321 and 322 and 321' and 322', the terminal bus bars are in contact with the sensing pins 323 and 323', and thus the second sensing members 320 and 320' and the terminal bus bars 220 and 220' are electrically connected.

Coupling protrusions 320a and 320a' coupled to the second sensing member coupling holes 516 of the heat propagation prevention plate 500 are provided on upper sides of rear surfaces of the second sensing members 320 and 320' of the present embodiment, respectively. In addition, a support block 340 coupled to the support block coupling hole 515 of the heat propagation prevention plate 500 is provided on a lower side of the rear surface of each of the second sensing members 320 and 320'. The support block 340 allows each of the second sensing members 320 and 320' to be firmly fastened to the heat propagation prevention plate 500. In addition, a hook 341 is provided at each of upper and lower ends of the support block 340, and inter-bus bars 210 and 210' located on a rear surface side of the second sensing member are fastened to the hooks 341. As described above, the second sensing members 320 and 320' of the present embodiment include coupling portions coupled to the heat propagation prevention plate 500 and the inter-bus bars 210 and 210', and thus the rigidity of the coupling structure of the longitudinal unit cells can be further improved.

Referring to FIG. 9, the second sensing members 320 and 320' are installed on rear sides of the terminal bus bars (first and second terminal bus bars 220 and 220'), respectively. The second sensing member is provided of two to correspond to the number of the terminal bus bars. When two sensing members are installed as described above, each of the battery cells 10 installed at the front and rear ends of the longitudinal unit cell 110 can be sensed to measure the electrical characteristics thereof.

The second sensing members 320 and 320' include the sensing pins 323 and 323' and the coupling hook portions 321 and 322 and 321' and 322' on the front surfaces thereof facing the terminal bus bars 220 and 220', respectively, so that the terminal bus bars 220 and 220' can be coupled to the second sensing members 320 and 320' by being fitted between the coupling hook portions 321 and 322 and 321' and 322', respectively. The coupling hook portions 321 and 322 and 321' and 322' may be provided in a shape fitted into the terminal bus bars 220 and 220' while surrounding left and right side portions or upper and lower portions of the terminal bus bars 220 and 220'. However, the shape of the hook portion is not limited thereto, and other types of hook portions can be employed for appropriate coupling.

The first and second terminal bus bars 220 and 220' may be respectively coupled to electrode leads protruding from the battery cells 10 on the front and rear sides of the longitudinal battery cells by, for example, welding. When the terminal bus bars 220 and 220' are coupled to the battery cells 10, the coupling hook portions 321 and 322 and 321' and 322' of the second sensing members 320 and 320' are fitted into and coupled to the terminal bus bars from rear sides of the terminal bus bars 220 and 220', respectively, thereby realizing a sensing integrated terminal bus bar.

A coupling structure of the terminal bus bar and the second sensing member when the heat propagation prevention plate 500 is interposed will be described as a modified example of the present embodiment. In this case, the assembly procedure is slightly different.

As shown in FIG. 3, the second sensing member coupling holes 516 are provided between the support plate 520 and the venting long holes 514 and 514' in the central portion of the heat propagation prevention plate 500. The coupling protrusions 320a and 320a' of the second sensing members 320 and 320' are fitted into and coupled to the second sensing member coupling holes 516. As necessary, the second sensing members 320 and 320' may be more firmly coupled to the heat propagation prevention plate 500 by thermally fusing the coupling protrusions 320a and 320a' fitted into the coupling holes.

Thereafter, when the first and second terminal bus bars 220 and 220' are fitted between and coupled to the coupling hook portions 321 and 322 and 321' and 322' on the front surfaces of the second sensing members 320 and 320', respectively, the terminal bus bar and the second sensing member can be conveniently coupled (see FIGS. 9B and 10B).

Next, as shown in FIG. 10C, two columns of the longitudinal unit cells 110 are located in a front side of the terminal bus bar, and the electrode leads 11 and 12 protruding from the battery cells 10 of the longitudinal unit cells 110 are respectively coupled to the terminal bus bars 220 and 220' to complete the assembly of the electrode lead, the terminal bus bar, and the second sensing member.

Meanwhile, the electrode leads of the battery cells 10 may be electrically connected to the inter-bus bar 210 on a side surface of the heat propagation prevention plate 500 opposite to the side surface to which the second sensing members 320 and 320' are assembled. In this case, a form similar to the coupling structure of the inter-bus bar 210 and the electrode lead of the first embodiment described above can be made.

That is, the inter-bus bar 210 is installed to pass through the inter-bus bar coupling hole 521 (see FIG. 3) of the support plate 520 that is vertically provided on the body portion of the heat propagation prevention plate 500. In this case, the insulating member 600 is installed on each of the left and right side surfaces of the support plate 520 as in the first embodiment, and the inter-bus bar 210 is coupled through the insulating member and the support plate, thereby more firmly coupling the inter-bus bar 210 to the heat propagation prevention plate 500. In addition, when the electrode leads of the battery cells 10, which face each other, of the longitudinal unit cell 110 are respectively coupled to the left and right sides of the inter-bus bar 210 installed to pass through the insulating member and the support plate, the electrode leads and the inter-bus bar 210 can be assembled.

In this case, the support block 340, which supports the second sensing members 320 and 320' and the inter-bus bar 210, may be installed between the inter-bus bar 210 and the heat propagation prevention plate 500. That is, as shown in FIG. 3, the support block 340 may be fitted into and installed to the support block coupling hole 515 below the second sensing member coupling holes 516 between the support plate 520 and the venting long holes 514 and 514'. For example, when the support block 340 is pushed and fitted into the support block coupling hole 515 while fitting the second sensing members 320 and 320' into the coupling holes 516 as shown in FIG. 9A, the support block 340 is in close contact with the inter-bus bar 210 so that the inter-bus bar 210 can be coupled more firmly as shown in FIG. 9B.

As described above, even in the present embodiment, the electrode leads, the terminal bus bar, the second sensing members 320 and 320', and the heat propagation prevention plate 500 form one rigid assembly, thereby realizing the sensing integrated bus bar structure firmly.

The battery module of the present invention may have each or both of the bus bar-sensing member coupling structure of the first embodiment described above and the bus bar-sensing member coupling structure of the second embodiment. One type of the coupling structures may be adopted for sensing in a unit of module. In this case, the inter-bus bar 210 or the terminal bus bars 220 and 220' and the first sensing member 310 or the second sensing member 320 are connected to an appropriate sensing line, thereby sensing electrical characteristics at a unit of module.

However, in order to accurately sense each battery cell 10 in addition to a unit of module, all of the bus bar-sensing member coupling structures of the first and second embodiments may be employed.

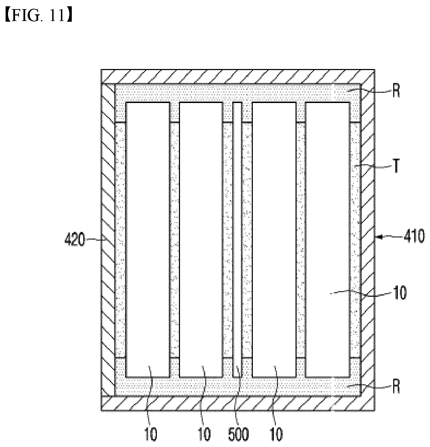

FIG. 11 is a cross-sectional view taken along line A-A' of FIG. 4.

As shown in FIG. 11, the longitudinal unit cells 110 constituting the battery cell assembly 100 may be adhered by an adhesive T. As described above, the heat propagation prevention plate 500 may be installed between the longitudinal unit cells 110, and the battery cell assembly 100 may be configured by adhering the heat propagation prevention plate 500 and the longitudinal unit cell 110. The battery cell assembly 100 may be mounted in the module case by further applying the adhesive T to an outer side surface of the battery cell assembly 100 facing the module case.

In particular, as shown in FIG. 11, a thermally conductive adhesive resin layer R may be filled or applied in at least one of a space between the module case 400 covering an upper portion of the battery cell assembly 100 and the battery cell assembly 100 and a space between the battery cell assembly 100 and the module case 400 located below the battery cell assembly 100. The thermally conductive adhesive resin layer R may use a silicon-based resin, a modified silicone resin, an acrylic resin, or the like. When the resin layer R is filled between the battery cell assembly 100 and the case, the battery cell assembly 100 can be fixed without moving in the module case 400. In addition, since the resin is a so-called thermal resin having thermal conductivity, the resin layer can efficiently absorb heat generated inside the battery module 1000. In addition, the thermal resin (thermally conductive adhesive resin layer R) can further improve heat dissipation efficiency by transferring heat to a cooling plate (not shown) installed on the upper portion of the battery module.

As described above, the battery cell assembly 100 is mounted in the module case 400, and is filled with the adhesive T and the thermally conductive adhesive resin layer R and fixed, thereby forming the expandable battery module 1000 in the form of FIG. 11.

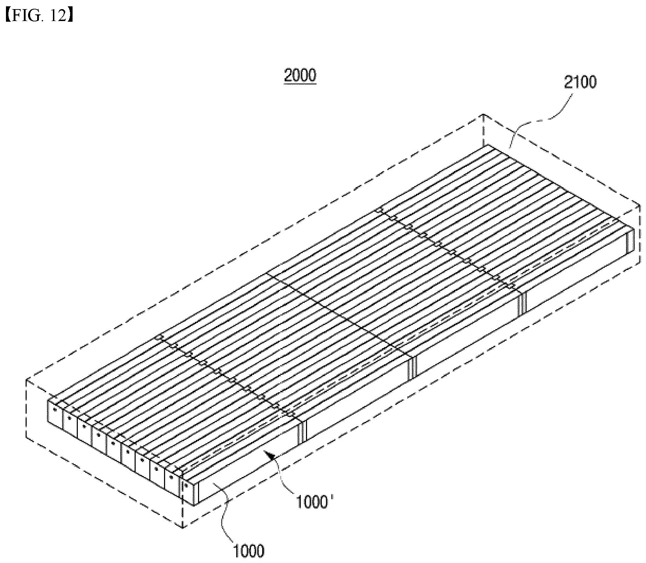

FIG. 12 is a schematic view of a battery pack including a battery stack composed of the battery module of the present invention.

As described above, the battery module 1000 of the present invention includes the battery cell assembly 100 in which the battery cell 10 is used as the longitudinal unit cell 110 and stacked in the thickness direction of the battery cell by a predetermined number, and a module case 400 extending long in the longitudinal direction to correspond thereto. Accordingly, a form in which the battery module 1000 is easily connected in the longitudinal direction or the thickness direction, such as a Lego block, is obtained. As shown in FIG. 12, a plurality of expandable battery modules 1000 may be stacked in the longitudinal direction and thickness direction of the battery cell 10 in one battery pack case 2100 to configure a battery module stack 1000'. The stacking direction (shape) of the expandable battery modules 1000 may be changed so as to correspond to the shape of the battery pack case 2100 to be applied in addition to that shown in FIG. 12. In this respect, it can say that the expandable battery module 1000 of the present invention has an extremely high degree of freedom in design.

Meanwhile, in the present specification, terms indicating directions such as "up," "down," "left,", "right," "front," and "rear" are used, but these terms are only for convenience of description, and it will be obvious to those skilled in the art that these terms may vary depending on positions of an object, positions of an observer, or the like.

## Claims

1. A battery module (1000), comprising:
a battery cell assembly (100) including two or more longitudinal unit cells (110), each of the two or more longitudinal unit cells (110) including two or more battery cells (10) arranged in a row in a longitudinal direction, wherein the battery cell (10) includes a pair of electrode leads (11, 12) at both ends in the longitudinal direction, and each of the two or more longitudinal unit cells (110) are stacked in two or more columns in a thickness direction of the battery cell (10);
a bus bar (200) coupled to each of the pair of electrode leads (11, 12) of the battery cell (10) included in the battery cell assembly (100) and electrically connecting the battery cells (10);
a sensing member (300) coupled to the bus bar (200) and sensing electrical characteristics of the battery cell (10); and
a module case (400) accommodating the battery cell assembly (100), the bus bar (200), and the sensing member (300),
wherein the bus bar (200) and the sensing member (300) are fastened by fitting coupling in which one of the bus bar (200) and the sensing member (300) is fitted into the other thereof so as to be fastened to the other.

2. The battery module of claim 1, wherein the bus bar (200) comprises an inter-bus bar (210, 210') to which each of the electrode leads (11, 12) of the battery cells (10) located at a front end of the longitudinal unit cells (110) and a rear end of the longitudinal unit cells (110) is coupled.

3. The battery module of claim 2, wherein
the same number of columns of longitudinal unit cells (110) are disposed on each of both sides of the inter-bus bar (210, 210') in the thickness direction of the battery cell (10), and
the electrode leads (11, 12) of the battery cells (10) located at the front and rear ends of the longitudinal unit cells (110) disposed on each of the both sides are bent toward the inter-bus bar (210, 210') and coupled to the inter-bus bar (210, 210').

4. The battery module of claim 2, wherein
a first sensing member (310) is installed on a rear side of the inter-bus bar (210, 210'), and
the first sensing member (310) includes a first hook portion (312) on a front surface thereof facing the inter-bus bar (210, 210'), and the inter-bus bar (210, 210') is coupled to the first sensing member (310) by being fitted the first hook portion (310).

5. The battery module of claim 2, further comprising a heat propagation prevention plate (500) installed to extend in the longitudinal direction of the battery cell (10) across a front end and a rear end of the module case (400) between the two or more columns of the longitudinal unit cells (110).

6. The battery module of claim 5, wherein
the inter-bus bar (210, 210') is installed through each of a front end portion and a rear end portion of the heat propagation prevention plate (500), and
the electrode leads (11, 12) of the battery cells (10) located at the front and rear ends of the longitudinal unit cells (110) disposed on each of both sides of the heat propagation prevention plate (500) are bent toward the inter-bus bar (210, 210') and coupled to the inter-bus bar (210, 210').

7. The battery module of claim 6, wherein
an insulating member (600) is installed on each of a left side surface and a right side surface of the heat propagation prevention plate (500) at the front end portion and the rear end portion, and
the inter-bus bar (210, 210') is installed through the insulating member (600) and the heat propagation prevention plate (500) at each of the front end portion and the rear end portion.

8. The battery module of claim 6, wherein
a first sensing member is installed on a rear side of the inter-bus bar (210, 210'), and
the first sensing member includes a first hook portion on a front surface thereof facing the inter-bus bar (210, 210'), and the inter-bus bar (210, 210') is coupled to the first sensing member by being fitted the first hook portion.

9. The battery module of claim 8, wherein
the first sensing member (310) is coupled by passing through the heat propagation prevention plate (500) at the rear side of the inter-bus bar (210, 210'),
the first sensing member (310) includes a second hook portion (313) fitted into an edge of a through portion (513, 513') of the heat propagation prevention plate (500), and
when the second hook portion (313) is fitted into the edge of the through portion (513, 513') to couple the first sensing member (310) and the heat propagation prevention plate (500), the inter-bus bar (210, 210') is fitted the first hook portion (312), and the first sensing member (310) is fitted into and coupled to the inter-bus bar (210, 210').

10. The battery module of claim 1, wherein the bus bar (200) comprises a terminal bus bar (220, 220') coupled to the electrode leads (11, 12) of the battery cells (10), which face in the longitudinal direction, in the longitudinal unit cell (110).

11. The battery module of claim 10, wherein the terminal bus bar (220, 220') includes a first terminal bus bar (220) coupled to an electrode lead (11, 12) or electrode leads (11, 12) of one side among the electrode leads (11, 12) of the battery cells (10) facing each other in the longitudinal direction, and a second terminal bus bar (220') coupled to an electrode lead (11, 12) or electrode leads (11, 12) of the other side among the electrode leads (11, 12) of the battery cells (10) facing each other in the longitudinal direction.

12. The battery module of claim 10, wherein
a second sensing member (320, 320') is installed on a rear side of the terminal bus bar (220, 220'), and
the second sensing member (320, 320') includes a coupling hook portion (321, 322, 321', 322') on a front surface facing the terminal bus bar (220, 220'), and the terminal bus bar (220, 220') is coupled to the second sensing member (320, 320') by being fitted the coupling hook portion (321, 322, 321', 322').

13. The battery module of claim 12, further comprising a heat propagation prevention plate (500) installed to extend in the longitudinal direction of the battery cell (10) across a front end and a rear end of the module case (400) between the two or more columns of the longitudinal unit cells (110),
wherein the second sensing member (320, 320') is coupled to the heat propagation prevention plate (500).

14. The battery module of claim 1, wherein a thermally conductive adhesive resin layer (R) is disposed in at least one of a space between the module case (400) covering an upper portion of the battery cell assembly (100) and the battery cell assembly (100), and a space between the battery cell assembly (100) and the module case (400) located below the battery cell assembly (100).

15. A battery pack (2000) comprising a battery module stack (1000') in which the battery module (1000) of any one of claims 1 to 14 in plural in at least one of the longitudinal direction and the thickness direction of the battery cell (10) are stacked.

## Patentansprüche

1. Batteriemodul (1000) aufweisend:
eine Batteriezellenanordnung (100) aufweisend zwei oder mehr länglichen Einheitszellen (110), wobei jede der zwei oder mehr länglichen Einheitszellen (110) zwei oder mehr Batteriezellen (10) enthält, die in einer Reihe in einer Längsrichtung angeordnet sind, wobei die Batteriezelle (10) zwei Elektrodenleitungen (11, 12) an jeweiligen Enden in der Längsrichtung aufweist, und jede der zwei oder mehr Längseinheitszellen (110) in zwei oder mehr Spalten in einer Dickenrichtung der Batteriezelle (10) gestapelt ist;
eine Sammelschiene (200), die mit jeder der zwei Elektrodenleitungen (11, 12) der Batteriezelle (10), die in der Batteriezellenanordnung (100) enthalten ist, gekoppelt ist und die Batteriezellen (10) elektrisch verbindet;
ein Erfassungselement (300), das mit der Sammelschiene (200) gekoppelt ist und elektrische Eigenschaften der Batteriezelle (10) erfasst; und
ein Modulgehäuse (400), das die Batteriezellenanordnung (100), die Sammelschiene (200) und das Erfassungselement (300) aufnimmt,
wobei die Sammelschiene (200) und das Erfassungselement (300) durch eine Passkopplung befestigt sind, in welcher entweder die Sammelschiene (200) in das Erfassungselement (300) oder umgekehrt eingepasst ist, um aneinander befestigt zu werden.

2. Batteriemodul nach Anspruch 1, wobei die Sammelschiene (200) eine Zwischensammelschiene (210, 210') aufweist, mit welcher jede der Elektrodenleitungen (11, 12) der Batteriezellen (10), die sich an einem vorderen Ende der Längseinheitszellen (110) und einem hinteren Ende der länglichen Einheitszellen (110) befinden, gekoppelt ist.

3. Batteriemodul nach Anspruch 2, wobei
die gleiche Anzahl von Spalten von länglichen Einheitszellen (110) auf jeder der beiden Seiten der Zwischensammelschiene (210, 210') in der Dickenrichtung der Batteriezelle (10) angeordnet ist, und
die Elektrodenleitungen (11, 12) der Batteriezellen (10), die sich an den vorderen und hinteren Enden der länglichen Einheitszellen (110) befinden, die auf jeder der beiden Seiten angeordnet sind, in Richtung der Zwischensammelschiene (210, 210') gebogen sind und mit der Zwischensammelschiene (210, 210') gekoppelt sind.

4. Batteriemodul nach Anspruch 2, wobei
ein erstes Erfassungselement (310) auf einer Rückseite der Zwischensammelschiene (210, 210') installiert ist, und
das erste Erfassungselement (310) einen ersten Hakenabschnitt (312) auf einer vorderen Oberfläche davon aufweist, die der Zwischensammelschiene (210, 210') zugewandt ist, und die Zwischensammelschiene (210, 210') mit dem ersten Erfassungselement (310) gekoppelt ist, indem sie in den ersten Hakenabschnitt (310) eingepasst ist.

5. Batteriemodul nach Anspruch 2, ferner aufweisend eine Wärmeausbreitungsverhinderungsplatte (500), die so installiert ist, dass sie sich in der Längsrichtung der Batteriezelle (10) quer zu einem vorderen Ende und einem hinteren Ende des Modulgehäuses (400) zwischen den zwei oder mehr Spalten der Längseinheitszellen (110) erstreckt.

6. Batteriemodul nach Anspruch 5, wobei
die Zwischensammelschiene (210, 210') durch einen vorderen Endabschnitt und einen hinteren Endabschnitt der Wärmeausbreitungsverhinderungsplatte (500) installiert ist, und
die Elektrodenleitungen (11, 12) der Batteriezellen (10), die sich an dem vorderen Ende und dem hinteren Ende der länglichen Einheitszellen (110) befinden, welche auf jeder der beiden Seiten der Wärmeausbreitungsverhinderungsplatte (500) angeordnet sind, in Richtung der Zwischensammelschiene (210, 210') gebogen sind und mit der Zwischensammelschiene (210, 210') gekoppelt sind.

7. Batteriemodul nach Anspruch 6, wobei
ein Isolierelement (600) auf einer linken Seitenoberfläche und einer rechten Seitenoberfläche der Wärmeausbreitungsverhinderungsplatte (500) an dem vorderen Endabschnitt und dem hinteren Endabschnitt installiert ist, und
die Zwischensammelschiene (210, 210') durch das Isolierelement (600) und die Wärmeausbreitungsverhinderungsplatte (500) an dem vorderen Endabschnitt und dem hinteren Endabschnitt installiert ist.

8. Batteriemodul nach Anspruch 6, wobei
ein erstes Erfassungselement auf einer Rückseite der Zwischensammelschiene (210, 210') installiert ist, und
das erste Erfassungselement einen ersten Hakenabschnitt auf einer vorderen Oberfläche davon aufweist, die der Zwischensammelschiene (210, 210') zugewandt ist, und die Zwischensammelschiene (210, 210') mit dem ersten Erfassungselement gekoppelt ist, indem sie in den ersten Hakenabschnitt eingepasst ist.

9. Batteriemodul nach Anspruch 8, wobei
das erste Erfassungselement (310) gekoppelt ist, indem es durch die Wärmeausbreitungsverhinderungsplatte (500) an der Rückseite der Zwischensammelschiene (210, 210') verläuft,
das erste Erfassungselement (310) einen zweiten Hakenabschnitt (313) aufweist, der in einen Rand eines Durchgangsabschnitts (513, 513') der Wärmeausbreitungsverhinderungsplatte (500) eingepasst ist, und
wenn der zweite Hakenabschnitt (313) in den Rand des Durchgangsabschnitts (513, 513') eingepasst ist, um das erste Erfassungselement (310) und die Wärmeausbreitungsverhinderungsplatte (500) zu koppeln, die Zwischensammelschiene (210, 210') in den ersten Hakenabschnitt (312) eingepasst ist und das erste Erfassungselement (310) in die Zwischensammelschiene (210, 210') eingepasst und mit dieser gekoppelt ist.

10. Batteriemodul nach Anspruch 1, wobei die Sammelschiene (200) eine Anschlusssammelschiene (220, 220') aufweist, die mit den Elektrodenleitungen (11, 12) der Batteriezellen (10), die in der Längsrichtung weisen, in der Längseinheitszelle (110) gekoppelt ist.

11. Batteriemodul nach Anspruch 10, wobei die Anschlusssammelschiene (220, 220') eine erste Anschlusssammelschiene (220), die mit einer Elektrodenleitung (11, 12) oder Elektrodenleitungen (11, 12) einer Seite unter den Elektrodenleitungen (11, 12) der Batteriezellen (10), die einander in der Längsrichtung zugewandt sind, gekoppelt ist, und eine zweite Anschlusssammelschiene (220') aufweist, die mit einer Elektrodenleitung (11, 12) oder Elektrodenleitungen (11, 12) der anderen Seite unter den Elektrodenleitungen (11, 12) der Batteriezellen (10), die einander in der Längsrichtung zugewandt sind, gekoppelt ist.

12. Batteriemodul nach Anspruch 10, wobei
ein zweites Erfassungselement (320, 320') auf einer Rückseite der Anschlusssammelschiene (220, 220') installiert ist, und
das zweite Erfassungselement (320, 320') einen Kopplungshakenabschnitt (321, 322, 321', 322') auf einer vorderen Oberfläche aufweist, die der Anschlusssammelschiene (220, 220') zugewandt ist, und die Anschlusssammelschiene (220, 220') mit dem zweiten Erfassungselement (320, 320') gekoppelt ist, indem sie in den Kopplungshakenabschnitt (321, 322, 321', 322') eingepasst ist.

13. Batteriemodul nach Anspruch 12, ferner aufweisend eine Wärmeausbreitungsverhinderungsplatte (500), die so installiert ist, dass sie sich in der Längsrichtung der Batteriezelle (10) quer zu einem vorderen Ende und einem hinteren Ende des Modulgehäuses (400) zwischen den zwei oder mehr Spalten der Längseinheitszellen (110) erstreckt,
wobei das zweite Erfassungselement (320, 320') mit der Wärmeausbreitungsverhinderungsplatte (500) gekoppelt ist.

14. Batteriemodul nach Anspruch 1, wobei eine thermisch leitfähige Klebeharzschicht (R) in mindestens einem von einem Raum zwischen dem Modulgehäuse (400), das einen oberen Abschnitt der Batteriezellenanordnung (100) abdeckt, und der Batteriezellenanordnung (100) und einem Raum zwischen der Batteriezellenanordnung (100) und dem Modulgehäuse (400), das sich unter der Batteriezellenanordnung (100) befindet, angeordnet ist.

15. Batteriepack (2000) aufweisend einen Batteriemodulstapel (1000'), in dem das Batteriemodul (1000) nach einem der Ansprüche 1 bis 14 mehrfach in mindestens einer von der Längsrichtung und der Dickenrichtung der Batteriezelle (10) gestapelt ist.

## Revendications

1. Module de batterie (1000) comprenant :
un ensemble de cellules de batterie (100) incluant deux cellules unitaires longitudinales ou plus (110), les deux cellules unitaires longitudinales ou plus (110) incluant chacune deux cellules de batterie ou plus (10) agencées en rang dans une direction longitudinale, dans lequel la cellule de batterie (10) inclut une paire de câbles d'électrode (11, 12) aux deux extrémités dans la direction longitudinale, et les deux cellules unitaires longitudinales ou plus (110) sont chacune empilées en deux colonnes ou plus dans une direction de l'épaisseur de la cellule de batterie (10) ;
une barre omnibus (200) couplée à chaque câble de la paire de câbles d'électrode (11, 12) de la cellule de batterie (10) inclus dans l'ensemble de cellules de batterie (100) et connectant électriquement les cellules de batterie (10) ;
un élément de détection (300) couplé à la barre omnibus (200) et détectant les caractéristiques électriques de la cellule de batterie (10) ; et
un boîtier de module (400) recevant l'ensemble de cellules de batterie (100), la barre omnibus (200) et l'élément de détection (300),
dans lequel la barre omnibus (200) et l'élément de détection (300) sont fixés par un couplage à ajustement où soit la barre omnibus (200), soit l'élément de détection (300) est ajusté dans l'autre de façon à être fixés l'un à l'autre.

2. Module de batterie selon la revendication 1, dans lequel la barre omnibus (200) comprend une barre inter-bus (210, 210') à laquelle chaque câble des câbles d'électrode (11, 12) des cellules de batterie (10) situé à une extrémité avant des cellules unitaires longitudinales (110) et à une extrémité arrière des cellules unitaires longitudinales (110) est couplé.

3. Module de batterie selon la revendication 2, dans lequel
le même nombre de colonnes de cellules unitaires longitudinales (110) sont disposées sur chacun des deux côtés de la barre inter-bus (210, 210') dans la direction de l'épaisseur de la cellule de batterie (10), et
les câbles d'électrode (11, 12) des cellules de batterie (10) situés aux extrémités avant et arrière des cellules unitaires longitudinales (110) disposées sur chacun des deux côtés sont courbés vers la barre inter-bus (210, 210') et couplés à la barre inter-bus (210, 210').

4. Module de batterie selon la revendication 2, dans lequel
un premier élément de détection (310) est installé sur un côté arrière de la barre inter-bus (210, 210'), et
le premier élément de détection (310) inclut une première partie crochet (312) sur une surface avant de celui-ci faisant face à la barre inter-bus (210, 210'), et la barre inter-bus (210, 210') est couplée au premier élément de détection (310) en étant ajustée à la première partie crochet (310).

5. Module de batterie selon la revendication 2, comprenant en outre une plaque de prévention de propagation de chaleur (500) installée pour s'étendre dans la direction longitudinale de la cellule de batterie (10) sur une extrémité avant et une extrémité arrière du boîtier de module (400) entre les deux colonnes ou plus des cellules unitaires longitudinales (110).

6. Module de batterie selon la revendication 5, dans lequel
la barre inter-bus (210, 210') est installée à travers une partie d'extrémité avant et une partie d'extrémité arrière de la plaque de prévention de propagation de chaleur (500), et
les câbles d'électrode (11, 12) des cellules de batterie (10) situés aux extrémités avant et arrière des cellules unitaires longitudinales (110) disposés sur chacun des deux côtés de la plaque de prévention de propagation de chaleur (500) sont courbés vers la barre inter-bus (210, 210') et couplés à la barre inter-bus (210, 210').

7. Module de batterie selon la revendication 6, dans lequel
un élément isolant (600) est installé sur une surface latérale de gauche et sur une surface latérale de droite de la plaque de prévention de propagation de chaleur (500) à la partie d'extrémité avant et à la partie d'extrémité arrière, et
la barre inter-bus (210, 21o') est installée à travers l'élément isolant (600) et la plaque de prévention de propagation de chaleur (500) à la partie d'extrémité avant et à la partie d'extrémité arrière.

8. Module de batterie selon la revendication 6, dans lequel
un premier élément de détection est installé sur un côté arrière de la barre inter-bus (210, 210'), et
le premier élément de détection inclut une première partie crochet sur une surface avant de celui-ci faisant face à la barre inter-bus (210, 210'), et la barre inter-bus (210, 210') est couplée au premier élément de détection en étant ajustée à la première partie crochet.

9. Module de batterie selon la revendication 8, dans lequel
le premier élément de détection (310) est couplée en passant à travers la plaque de prévention de propagation de chaleur (500) au côté arrière de la barre inter-bus (210, 210'),
le premier élément de détection (310) inclut une deuxième partie crochet (313) ajustée dans un bord d'une partie traversante (513, 513') de la plaque de prévention de propagation de chaleur (500), et
quand la deuxième partie crochet (313) est ajustée dans le bord de la partie traversante (513, 513') pour coupler le premier élément de détection (310) et la plaque de prévention de propagation de chaleur (500), la barre inter-bus (210, 210') est ajustée dans la première partie crochet (312), et le premier élément de détection (310) est ajusté dans et couplé à la barre inter-bus (210, 210').

10. Module de batterie selon la revendication 1, dans lequel la barre omnibus (200) comprend une barre omnibus de borne (220, 220') couplée aux câbles d'électrode (11, 12) des cellules de batterie (10), qui font face dans la direction longitudinale, dans la cellule unitaire longitudinale (110).

11. Module de batterie selon la revendication 10, dans lequel la barre omnibus de borne (220, 220') inclut une première barre omnibus de borne (220) couplée à un câble d'électrode (11, 12) ou à des câbles d'électrode (11, 12) d'un côté parmi les câbles d'électrode (11, 12) des cellules de batterie (10) dans la direction longitudinale, et une deuxième barre omnibus de borne (220') couplée à un câble d'électrode (11, 12) ou à des câbles d'électrode (11, 12) de l'autre côté parmi les câbles d'électrode (11, 12) des cellules de batterie (10) se faisant face dans la direction longitudinale.

12. Module de batterie selon la revendication 10, dans lequel
un deuxième élément de détection (320, 320') est installé sur un côté arrière de la barre omnibus de borne (220, 220'), et
le deuxième élément de détection (320, 320') inclut une partie crochet de couplage (321, 322, 321', 322') sur une surface avant faisant face à la barre omnibus de borne (220, 220'), et la barre omnibus de borne (220, 220') est couplée au deuxième élément de détection (320, 320') en étant ajustée à la partie crochet de couplage (321, 322, 321', 322').

13. Module de batterie selon la revendication 12, comprenant en outre une plaque de prévention de propagation de chaleur (500) installée pour s'étendre dans la direction longitudinale de la cellule de batterie (10) sur une extrémité avant et sur une extrémité arrière du boîtier de module (400) entre les deux colonnes ou plus des cellules unitaires longitudinales (110),
dans lequel le deuxième élément de détection (320, 320') est couplé à la plaque de prévention de propagation de chaleur (500).

14. Module de batterie selon la revendication 1, dans lequel une couche de résine thermoconductrice (R) est disposée dans soit un espace entre le boîtier de module (400) couvrant une partie supérieure de l'ensemble de cellules de batterie (100) et l'ensemble de cellules de batterie (100), soit un espace entre l'ensemble de cellules de batterie (100) et le boîtier de module (400) situé l'ensemble de cellules de batterie (100).

15. Bloc-batterie pack (2000) comprenant un empilement de modules de batterie (1000') dans lequel le module de batterie (1000) selon l'une quelconque des revendications 1 à 14 étant plusieurs dans soit la direction longitudinale, soit et la direction de l'épaisseur de la cellule de batterie (10) sont empilés.
